(19) Europäisches Patentamt
European Patent Office
Office européen des brevets

(11) **EP 2 779 258 B1**

(12) **EUROPÄISCHE PATENTSCHRIFT**

(45) Veröffentlichungstag und Bekanntmachung des Hinweises auf die Patenterteilung:
**16.09.2015   Patentblatt 2015/38**

(51) Int Cl.:
**H01L 39/24** *(2006.01)*

(21) Anmeldenummer: **13159230.5**

(22) Anmeldetag: **14.03.2013**

(54) **Monofilament zur Herstellung eines Nb3Sn-Supraleiterdrahts**

Monofilament for producing an Nb3Sn superconducting wire

Monofilament pour la fabrication d'un fil supraconducteur Nb3Sn

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.09.2014   Patentblatt 2014/38**

(73) Patentinhaber: **Bruker EAS GmbH**
**63450 Hanau (DE)**

(72) Erfinder: **Thöner, Manfred**
**63599 Biebergemünd (DE)**

(74) Vertreter: **Kohler Schmid Möbus Patentanwälte Partnerschaftsgesellschaft mbB**
**Ruppmannstraße 27**
**70565 Stuttgart (DE)**

(56) Entgegenhaltungen:
**EP-A1- 0 169 596      EP-A2- 1 705 721**
**WO-A1-2006/010364**

EP 2 779 258 B1

## Beschreibung

Die Erfindung betrifft ein Monofilament zur Herstellung eines Supraleiterdrahts, mit

- einem Pulverkern, der zumindest Sn und Cu enthält,
- einem inneren Rohr, das den Pulverkern umhüllt,
- einem äußeren Rohr, in welchem das innere Rohr angeordnet ist, wobei das innere Rohr mit seiner Außenseite die Innenseite des äußeren Rohrs berührt, und wobei das äußere Rohr aus Nb oder einer Nb-haltigen Legierung gefertigt ist, und
- einem Hüllrohr, in welchem das äußere Rohr angeordnet ist.

Ein solches Monofilament ist bekannt geworden durch die EP 0 169 596 A1.

$Nb_3Sn$ ist ein verbreitetes supraleitendes Material, insbesondere für die Fertigung von supraleitenden Magnetspulen. $Nb_3Sn$-Supraleiterdrähte erreichen im Vergleich zu anderen metallischen Tieftemperatur-Supraleitermaterialien (wie NbTi) technisch relevante Stromdichten in höheren Magnetfeldern. Allerdings ist die Herstellung und Verarbeitung von $Nb_3Sn$-Supraleiterdrähten schwierig, da $Nb_3Sn$ ein relativ sprödes Material ist und daher nicht (bzw. nur in minimalem Umfang) plastisch verformt werden kann.

$Nb_3Sn$-Drähte werden üblicherweise nach der Bronze-Route, der Internen Zinn-Diffusions-Technik oder der Pulver-in-Rohr-Technik (powder in tube, PIT) hergestellt. In allen drei Fällen wird dabei die Fertigung aufgeteilt in eine Halbzeugfertigung einerseits und eine Reaktionsglühung andererseits. Erst bei der Reaktionsglühung entsteht das spröde $Nb_3Sn$; nach der Reaktionsglühung ist in der Regel keine Verformung des Supraleiterdrahtes mehr vorgesehen.

Bei der Pulver-in-Rohr-Technik, wie sie beispielsweise aus der EP 0 169 596 A1 bekannt geworden ist, wird ein Sn-haltiges Pulvergemisch in einem inneren Rohr, üblicherweise aus Kupfer, angeordnet, und das innere Rohr wird wiederum in ein äußeres Rohr, üblicherweise aus Nb, eingeführt. Das äußere Rohr ist wiederum in einem runden, leitfähigen Matrixrohr (Hüllrohr), üblicherweise aus Cu, angeordnet. Mehrere solche Monofilamente können gebündelt werden. Durch die Reaktionsglühung, bei der das Sn aus dem Pulvergemisch mit dem Nb aus dem äußeren Rohr unter katalytischer Mitwirkung des Cu aus dem inneren Rohr oder als Zusatz des Pulvergemischs zu $Nb_3Sn$ reagiert, kann über die Pulver-in-Rohr-Technik ein Supraleiterdraht mit hoher supraleitender Stromtragfähigkeit erhalten werden.

Aus H. Veringa et al., Adv. Cryo. Eng. (Materials), 1984; 30, S. 813-821, ist ein Supraleiterdraht bekannt geworden, für den $NbSn_2$-Pulver mit einem Cu-Zusatz in ein Nb-Rohr eingebracht wird, das Nb-Rohr in ein hexagonales Kupferrohr eingebracht wird, und mehrere solchermaßen befüllte Kupferrohre in einem Bündelungsrohr aus Kupfer angeordnet werden und nach Extrudieren und Ziehen getempert werden. Ein ähnliches Vorgehen ist auch aus A.C.A. van Wees et al., IEEE Trans. Magn., MAG 19, 556 (1983), S. 5-8, bekannt geworden.

Weitere Filamente sind aus EP 1 705 721 A2 und WO 2006/010364 A1 bekannt.

Aufgabe der Erfindung

Es ist die Aufgabe der vorliegenden Erfindung, die supraleitende Stromtragfähigkeit des Supraleiterdrahtes weiter zu erhöhen.

Kurze Beschreibung der Erfindung

Diese Aufgabe wird gelöst durch ein Monofilament gemäß Anspruch 1. Ein zugehöriges Verfahren wird durch Anspruch 10, eine entsprechende Vorstufe wird durch Anspruch 14 definiert. Dadurch, dass das innere Rohr aus Nb oder einer Nb-haltigen Legierung gefertigt ist, wird nach dem Reaktionsglühen ein feineres und homogeneres Gefüge von $Nb_3Sn$-Körnern erhalten, insbesondere im Bereich der vorherigen Grenzfläche von innerem Rohr und Pulverkern, verglichen mit der Verwendung eines inneren Rohrs aus Kupfer. Ebenso werden Hohlräume (etwa Spalten) in diesem Bereich nach dem Reaktionsglühen vermieden oder zumindest verringert. Beides führt zu einer deutlichen Erhöhung der supraleitenden Stromtragfähigkeit des fertigen Supraleiterdrahts; die Erfinder haben eine Steigerung der kritischen Stromdichte um den Faktor 1,5 bis 2 beobachtet.

Weiterhin ist die nach außen fortschreitende Reaktionsfront von $Nb_3Sn$ während des Reaktionsglühens besser kontrollierbar; insbesondere können Durchbrüche der Reaktionsfront in das Hüllrohr (Matrix) und damit eine Verunreinigung des Hüllrohrs (das meist aus Cu gefertigt ist) leicht verhindert werden. Entsprechend kann der Restwiderstand des Hüllrohrs niedrig (bzw. der RRR-Wert hoch) gehalten werden.

Überraschender Weise haben sich bei Verwendung eines inneren Rohrs aus Nb oder einer Nb-haltigen Legierung keine merklichen Probleme im Verformungsverhalten, etwa beim Ziehen des befüllten Innenrohrs allein, beim Ziehen des Monofilaments oder beim Ziehen einer Vorstufe eines Supraleiterdrahts mit mehreren gezogenen Monofilamenten, ergeben. Insbesondere wurde keine Häufung von Filamentbrüchen im reagierten Supraleiterdraht beobachtet.

Durch das innere Rohr kann der enthaltene Pulverkern in einem Ziehprozess vor einem Einsetzen in das äußere Rohr gut verdichtet werden. Der Hauptteil des für die Bildung des $Nb_3Sn$ benötigten Niobs kann vom äußeren Rohr bereitgestellt werden, so dass das innere Rohr auch recht dünnwandig gewählt werden kann.

Das innere Rohr hat typischerweise einen Nb-Gehalt von wenigstens 80 Gew%, bevorzugt wenigstens 90 Gew%; weiterhin ist das innere Rohr typischerweise kupferfrei. Entsprechendes gilt für das äußere Rohr. Der Pulverkern enthält typischerweise eine Mischung von verschiedenen Pulvern unterschiedlicher Zusammensetzung, darunter das zur Beschleunigung der Bildung des $Nb_3Sn$ notwendige Cu. Das Cu liegt bevorzugt elementar vor, während das Sn in der Regel zumindest teilweise legiert (vorzugsweise legiert mit Nb) vorliegt.

Bevorzugte Ausführungsformen der Erfindung

Bei einer besonders vorteilhaften Ausführungsform des erfindungsgemäßen Monofilaments weist das Hüllrohr einen hexagonalen Außenquerschnitt und einen runden Innenquerschnitt auf. In diesem Fall kann ein äußeres Rohr mit rundem Außenquerschnitt (und rundem Innenquerschnitt) eingesetzt werden, welches seinen Außenquerschnitt im Rahmen von Bündelungsprozessen nicht zu ändern braucht. Insbesondere braucht dem Hüllrohr kein hexagonaler Außenquerschnitt mehr in einem Ziehschritt des Monofilaments aufgeprägt zu werden, was auch zu einem näherungsweise hexagonalen Außenquerschnitt des zuvor runden äußeren Rohrs führen würde (der Innenquerschnitt bliebe im Wesentlichen rund). Dadurch kann das äußere Rohr eine gleichmäßige Wandstärke behalten, insbesondere auch zu Beginn des Reaktionsglühens. Die Bildung von $Nb_3Sn$ kann dann gleichmäßig von innen in das äußere Rohr hinein erfolgen, ohne dass an einer dünnen Stelle ein frühzeitiger Durchbruch von Sn in das Hüllrohr befürchtet werden müsste und ohne dass unreagierte Eckbereiche verbleiben. Entsprechend kann ein besonders großer Anteil der Querschnittsfläche des Monofilaments zu $Nb_3Sn$ reagieren, der dann für den supraleitenden Stromtransport zur Verfügung steht. Da das reagierte Volumen an $Nb_3Sn$ zudem noch aufgrund seines feinen Gefüges eine recht hohe Stromdichte zu transportieren vermag, potenzieren sich in dieser Ausführungsform die Vorteile der Erfindung zu einer besonders hohen Stromtragfähigkeit je Monofilament bzw. des Supraleiterdrahts insgesamt. Alternativ zu dieser Ausführungsform kann das Hüllrohr auch einen runden Außenquerschnitt haben; für eine nachfolgende Bündelung muss dann in einem Ziehschritt ein hexagonaler Außenquerschnitt noch aufgeprägt werden.

Bei einer Ausführungsform weist das innere Rohr einen runden Innenquerschnitt und einen runden Außenquerschnitt auf, und das äußere Rohr weist einen runden Innenquerschnitt und einen runden Außenquerschnitt auf. In diesem Fall kann die Reaktion von Sn und Nb zu $Nb_3Sn$ besonders gleichmäßig erfolgen, insbesondere mit einer (kreis-)runden Reaktionsfront im Monofilament.

Bevorzugt ist dabei eine Weiterbildung dieser Ausführungsform, bei der gilt

$$1{,}2 \leq D^{au\text{ß}en}_{\ddot{a}u\text{ß}eresRohr} / D^{au\text{ß}en}_{inneres\ Rohr} \leq 2{,}0$$

mit $D^{au\text{ß}en}_{\ddot{a}u\text{ß}eresRohr}$: Außendurchmesser des äußeren Rohres und $D^{au\text{ß}en}_{inneres}$ Rohr : Außendurchmesser des inneren Rohres.

Außerdem gilt bei einer erfindungsgemäßen Ausführung

$$4 \leq W_{\ddot{a}u\text{ß}eres\ Rohr} / W_{inneres\ Rohr} \leq 50$$

mit $W_{\ddot{a}u\text{ß}eresRoh}$: Wandstärke äußeres Rohr und $W_{inneres\ Rohr}$ : Wandstärke inneres Rohr. Diese Bereiche von Durchmesserverhältnissen und Wandstärkeverhältnissen haben sich in der Praxis bewährt; insbesondere wurde keine Häufung von Filamentbrüchen im reagierten Supraleiterdraht beobachtet.

Vorteilhaft ist weiterhin eine Ausführungsform, bei der der Pulverkern einen Anteil von 2 Gew% bis 12 Gew% Cu aufweist, bevorzugt 3 bis 9 Gew% Cu, insbesondere wobei der Pulverkern elementares Cu-Pulver enthält. Der Cu-Zusatz im Pulverkern hat für die $Nb_3Sn$ -Bildung katalytische Wirkung und vermindert die Reaktionstemperatur. In der Praxis reicht für eine effiziente Reaktion oft schon ein Kupferanteil im Pulverkern bis 5 Gew% aus. Durch einen Verzicht auf ein inneres Rohr aus Kupfer kann der gesamte Kupferanteil im Reaktionsbereich des Monofilaments relativ frei gewählt werden, insbesondere niedriger als bei Verwendung eines inneren Rohrs aus Kupfer, und zudem kann das Kupfer besser im Reaktionsbereich verteilt werden, insbesondere gleichmäßig im Pulverkern.

Bevorzugt ist weiterhin eine Ausführungsform, bei der der Pulverkern im inneren Rohr verdichtet vorliegt, insbesondere mit einer Dichte von wenigstens 40%, bevorzugt wenigstens 50% der theoretischen Dichte. Die Verdichtung kann insbesondere durch einen Ziehprozess des befüllten inneren Rohrs vor einem Einfügen in das äußere Rohr erfolgen.

Durch die (Vor-)Verdichtung wird die plastische Verformbarkeit des Fertigleiters (Vorstufe des Supraleiterdrahts) vor dem Reaktionsglühen insgesamt verbessert.

Bei einer bevorzugten Ausführungsform enthält der Pulverkern $NbSn_2$ und/oder $Nb_6Sn_5$ und/oder elementares Sn. Diese Materialien können im Rahmen der vorliegenden Erfindung gut als Zinnquellen eingesetzt werden. Meist wird eine Kombination von zwei oder auch von allen drei Materialien eingesetzt.

Vorteilhaft ist weiterhin eine Ausführungsform, bei der das innere Rohr und/oder das äußere Rohr aus einer Nb-haltigen Legierung enthaltend Ta und/oder Ti gefertigt sind, insbesondere mit einem Gehalt von wenigstens 0,5 Gew% von Ta und/oder Ti in Summe, und insbesondere mit einem Gehalt von maximal 10 Gew% von Ta und/oder Ti in Summe. Geringe Zusätze von Tantal und/oder Titan beeinflussen positiv die Bildungskinetik und das Gefüge von $Nb_3Sn$ und erhöhen die erreichbare kritische Stromdichte; gemäß der Ausführungsform sollten die Zusätze von Tantal und Titan zusammen bevorzugt maximal 10 Gew% ausmachen, um unerwünschte Phasen zu vermeiden. Daneben kommen als Legierungszusätze auch Hf oder Zr in Betracht.

Bevorzugt ist auch eine Ausführungsform, bei der das innere Rohr und das äußere Rohr aus unterschiedlichen Materialien gefertigt sind. Dadurch können unterschiedliche Eigenschaften im inneren und im äußeren Hüllrohr eingestellt werden. Insbesondere kann das innere Rohr durch geeignete Zusammensetzung und/oder Gefügeeinstellung so gewählt werden, dass die Außenseite des inneren Rohrs bei der Befüllung mit dem Pulverkern und bei einem Ziehprozess möglichst wenig verformt wird, um das nachfolgende Einfügen in das äußere Rohr zu erleichtern. Beispielsweise kann das äußere Rohr aus NbTa7,5 und das innere Rohr aus Nb bestehen. Alternativ können auch die Materialien von innerem Rohr und äußerem Rohr gleich gewählt werden.

Vorteilhaft ist weiterhin eine Ausführungsform, bei der das Hüllrohr aus Cu gefertigt ist. Kupfer besitzt eine hohe Leitfähigkeit und vermag so im Quenchfall (Verlust der Supraleitung) als paralleler Strompfad nahe des $Nb_3Sn$-Filaments dieses zu schützen.

In den Rahmen der vorliegenden Erfindung fällt auch ein Verfahren zur Fertigung eines erfindungsgemäßen, oben beschriebenen Monofilaments, gekennzeichnet durch folgende Schritte:

a) der Pulverkern wird zunächst in das ungezogene innere Rohr gefüllt und anschließend wird das befüllte ungezogene innere Rohr gezogen, wobei eine Verdichtung des Pulverkerns eintritt;
b) das äußere Rohr wird in das Hüllrohr eingesetzt, und
c) das gezogene, befüllte innere Rohr wird in das äußere Rohr eingesetzt,

wobei Schritt b) vor oder nach Schritt c) stattfindet.
Bevorzugt erfolgt Schritt b) vor Schritt c). Das ungezogene innere Rohr ist bevorzugt dünnwandig, beispielsweise mit einem Verhältnis von Wandstärke zu Außendurchmesser von 1/25 bis 1/60, wodurch eine besonders hohe Verdichtung des Pulverkerns in Schritt a) erreicht werden kann.

Besonders vorteilhaft ist eine Variante des erfindungsgemäßen Verfahrens zur Fertigung eines Monofilaments, wobei bereits vor Schritt b) das Hüllrohr einen hexagonalen Außenquerschnitt aufweist. Dadurch braucht für eine Bündelung der Monofilamente kein Ziehen auf einen hexagonalen Außenquerschnitt erfolgen, und das äußere Rohr kann innen und außen rund bleiben. Ein hoher Anteil des Querschnitts jedes Monofilaments kann für die Bildung von $Nb_3Sn$ mit sehr homogenem und feinem Gefüge genutzt werden. Dadurch können besonders hohe supraleitende Stromtragfähigkeiten erreicht werden (siehe dazu oben).

Ebenfalls in den Rahmen der vorliegenden Erfindung fällt ein Verfahren zur Fertigung einer Vorstufe eines Supraleiterdrahts, gekennzeichnet durch folgende Schritte:

a') durch Ziehen eines oder mehrerer, erfindungsgemäßer Monofilamente werden gezogene Monofilamente mit hexagonalem Außenquerschnitt gefertigt;
b') mehrere gezogene Monofilamente werden in einem Drahthüllrohr gebündelt,
c') das Drahthüllrohr, das die gebündelten gezogenen Monofilamente enthält, wird extrudiert und/oder gezogen, wodurch die Vorstufe des Supraleiterdrahts erhalten wird. Durch den Ziehschritt gemäß a') kann der Kontakt zwischen innerem Rohr und äußerem Rohr verbessert werden (insbesondere können etwaige Spalten geschlossen werden) und es kann eine weitere Kompaktierung erreicht werden, sodass mehr Monofilamente in Schritt b') gebündelt werden können. Ebenso kann die Größe der Monofilamente und nötigenfalls die Form der Monofilamente für Schritt b') eingestellt werden. Durch Schritt c') wird die Vorstufe des Supraleiterdrahts auf die für die Anwendung (etwa eine zu wickelnde Magnetspule) gewünschte Größe und Querschnittsform gebracht. Das Drahthüllrohr ist typischerweise aus Cu gefertigt, um einen niedrigen Restwiderstand zu gewährleisten.

Bei einer Variante des erfindungsgemäßen Verfahrens zur Fertigung einer Vorstufe eines Supraleiterdrahts ist vorgesehen, dass in Schritt a') das oder die Monofilamente bereits vor dem Ziehen einen hexagonalen Außenquerschnitt des Hüllrohrs und einen runden Außenquerschnitt des äußeren Rohrs aufweisen, und nach dem Ziehen die gezogenen Monofilamente ebenfalls einen hexagonalen Außenquerschnitt des Hüllrohrs und einen runden Außenquerschnitt des äußeren Rohrs aufweisen. Die Monofilamente werden beim Ziehen in Schritt a') also lediglich "radial gestaucht"; dies ist besonders einfach und vermeidet die Aufprägung einer äußeren Formänderung des Hüllrohrs auch im Inneren, etwa auf das äußere Rohr.

Weiterhin fällt in den Rahmen der Erfindung eine Vorstufe eines Supraleiterdrahts, hergestellt durch ein oben beschriebenes, erfindungsgemäßes Verfahren. Aus der Vorstufe kann ein Supraleiterdraht mit besonders hoher Stromtragfähigkeit gefertigt werden.

Ebenso fällt in den Rahmen der Erfindung ein Verfahren zur Fertigung eines Supraleiterdrahts aus einer oben beschriebenen, erfindungsgemäßen Vorstufe eines Supraleiterdrahts, gekennzeichnet durch folgende Schritte:

d') die Vorstufe des Supraleiterdrahts wird mechanisch verformt, insbesondere zu einer Spule gewickelt;
e') die verformte Vorstufe des Supraleiterdrahts wird getempert, insbesondere bei einer maximalen Temperatur von 700°C oder weniger, wobei Nb aus dem inneren Rohr und dem äußeren Rohr mit Sn aus dem Pulverkern zu $Nb_3Sn$ reagiert. Der solchermaßen gefertigte Supraleiterdraht kann eine besonders hohe supraleitende Stromtragfähigkeit erreichen. In Schritt d') wird die Vorstufe in eine für die gewünschte Anwendung gewünschte (und nach dem Reaktionsglühen von Schritt e') nicht mehr veränderbare) Form gebracht. In dieser Form erfolgt sodann das Tempern gemäß Schritt e'). Typische Anwendungen sind Magnetspulen, insbesondere für spektroskopische NMR- und bildgebende MRI-Apparaturen.

Bevorzugt ist dabei eine Variante des erfindungsgemäßen Verfahrens zur Fertigung eines Supraleiterdrahts, wobei in Schritt e') das Tempern beendet wird, bevor eine nach außen fortschreitende Reaktionsfront die Grenzfläche zwischen äußerem Rohr und dem Hüllrohr erreicht. Dadurch wird ein Eintrag von Verunreinigungen in die Hüllrohre der enthaltenen Monofilamente vermieden, so dass der Restwiderstand der Hüllrohre niedrig gehalten werden kann. Die Hüllrohre stellen im Quenchfall dann leistungsfähige, zu den $Nb_3Sn$-Filamenten parallele Strompfade zum Schutz des Supraleiterdrahtes vor einem Durchbrennen zur Verfügung. Da der Fortschritt der Reaktionsfront beim Tempern relativ gleichmäßig erfolgt, kann ein geeigneter Zeitpunkt für eine Abkühlung zur Beendigung des Reaktionsfortschritts für verschiedene Drahtgeometrien durch wenige Versuche mit verschiedenen Glühdauern leicht gefunden werden. Die Reaktionsfronten sind beispielsweise im Rasterelektronenmikroskop im Querschliff gut zu erkennen.

Schließlich fällt auch in den Rahmen der Erfindung ein Supraleiterdraht, hergestellt durch ein oben beschriebenes, erfindungsgemäßes Verfahren. Der Supraleiterdraht weist wie bereits beschrieben eine besonders hohe Stromtragfähigkeit auf.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1    eine schematische Querschnittsdarstellung einer ersten Ausführungsform eines erfindungsgemäßen Monofilaments, mit hexagonalem Hüllrohr;

Fig. 2    eine schematische Querschnittsdarstellung einer zweiten Ausführungsform eines erfindungsgemäßen Monofilaments, mit rundem Hüllrohr;

Fig. 3    eine schematische Querschnittsdarstellung einer Ausführungsform einer erfindungsgemäßen Vorstufe eines Supraleiterd rahts;

Fig. 4    eine schematische Übersicht über die Fertigung eines erfindungsgemäßen Monofilaments;

Fig. 5    eine schematische Übersicht über die Fertigung eines erfindungsgemäßen Supraleiterdrahts;

Fig. 6    eine schematische Querschnittsdarstellung eines erfindungsgemäßen Supraleiterdrahts, in einem Ausschnitt im Bereich eines Monofilaments.

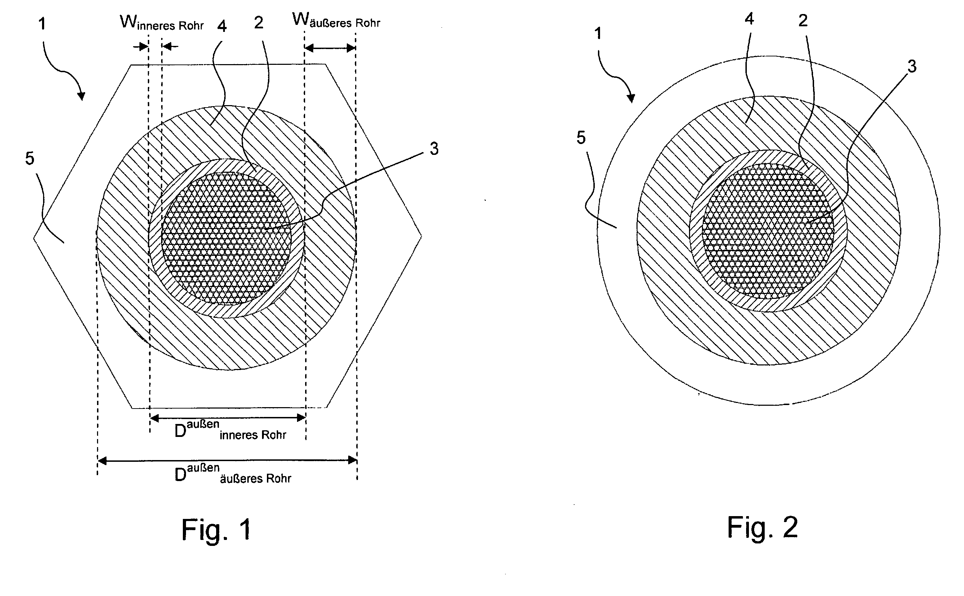

Die **Figur 1** zeigt schematisch eine erste Ausführungsform eines erfindungsgemäßen Monofilaments 1 im Querschnitt senkrecht zu seiner Längsrichtung.

Das Monofilament 1 weist ein inneres Rohr 2 auf, das in der gezeigten Ausführungsform aus Niob besteht. Im inneren Rohr 2 ist ein Pulverkern 3 aus einer Mischung von hier $NbSn_2$-Pulver, Sn-Pulver und Cu-Pulver angeordnet; der Anteil von Cu beträgt ca. 5 Gew% in der Mischung, und der Anteil von Sn in der Mischung typischerweise wenigstens 50 Gew%.

Das innere Rohr 2 ist in einem äußeren Rohr 4 angeordnet, welches hier aus NbTa7,5 besteht. Das innere Rohr 2 liegt dabei mit seiner Außenseite direkt an der Innenwand des äußeren Rohrs 4 an. Das innere Rohr 2 und das äußere Rohr 4 weisen jeweils (kreis-)runde Innen- und Außenquerschnitte auf.

Das äußere Rohr 4 ist wiederum in einem Hüllrohr 5 angeordnet; dieses besteht hier aus elementarem Kupfer. In der gezeigten Ausführungsform weist das Hüllrohr 5 einen runden Innenquerschnitt auf, so dass das äußere Rohr 4 flächig im Hüllrohr 5 anliegen kann; der Außenquerschnitt des Hüllrohrs 5 ist hexagonal ausgebildet ("Sechskantrohr"). Letzteres erhöht im fertigen Supraleiterdraht den für $Nb_3Sn$ nutzbaren Flächenanteil.

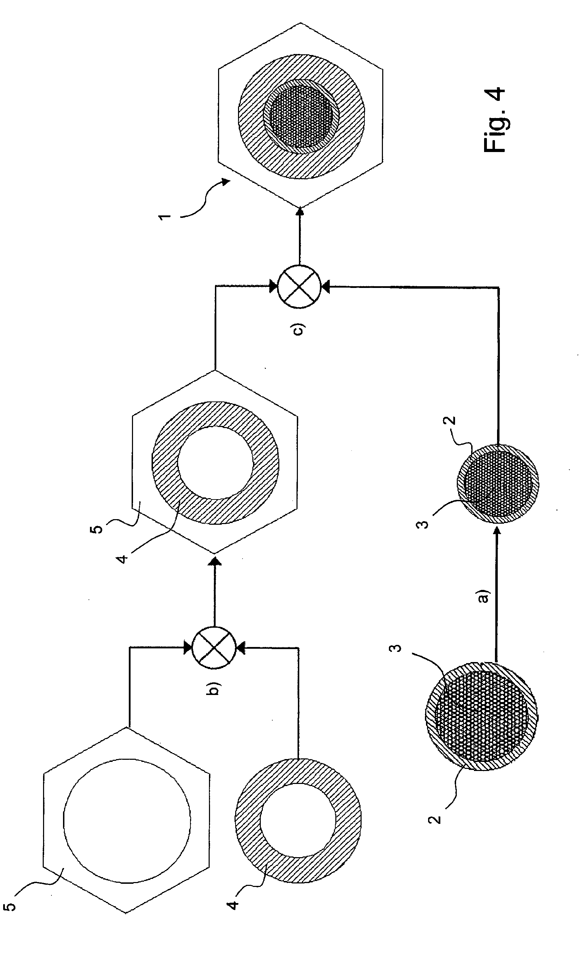

Die Hauptquelle von Nb für die Reaktionswärmebehandlung stellt das äußere Rohr 4 dar; das innere Rohr 2 ermöglicht aufgrund seiner vergleichsweise dünnen Wand eine gute Verdichtung des Pulverkerns 3 in einem vorausgehenden Ziehschritt (siehe dazu auch Fig. 4). In der exemplarisch gezeigten Ausführungsform beträgt das Verhältnis VD des Außendurchmessers $D^{außen}_{äußeres\ Rohr}$ des äußeren Rohrs 4 und des Außendurchmessers $D^{außen}_{inneres}$ Rohr des inneren Rohrs 2 ca. 1,65. Weiterhin beträgt das Verhältnis VW der Wandstärke $W_{äußeres}$ Rohr des äußeren Rohrs 4 und der Wandstärke $W_{inneres}$ Rohr des inneren Rohrs 2 ca. 4,2. Inneres Rohr 2, äußeres Rohr 4 und Hüllrohr 5 sind konzentrisch angeordnet. Im Monofilament 1 werden keine Lote benötigt.

Die **Figur 2** zeigt schematisch eine zweite Ausführungsform eines erfindungsgemäßen Monofilaments 1 im Querschnitt senkrecht zu seiner Längserstreckung.

Die zweite Ausführungsform des Monofilaments 1 ähnelt weitgehend der Ausführungsform von Fig. 1, insbesondere bezüglich innerem Rohr 2, Pulverkern 3 und äußerem Rohr 4.

Das Hüllrohr 5 ist hier jedoch mit einem (kreis-)runden Außenquerschnitt versehen; dadurch ist das Monofilament 1 einfach zu fertigen. Das Hüllrohr 5 ist auch hier aus elementarem Kupfer gefertigt und weist einen (kreis-)runden Innenquerschnitt auf.

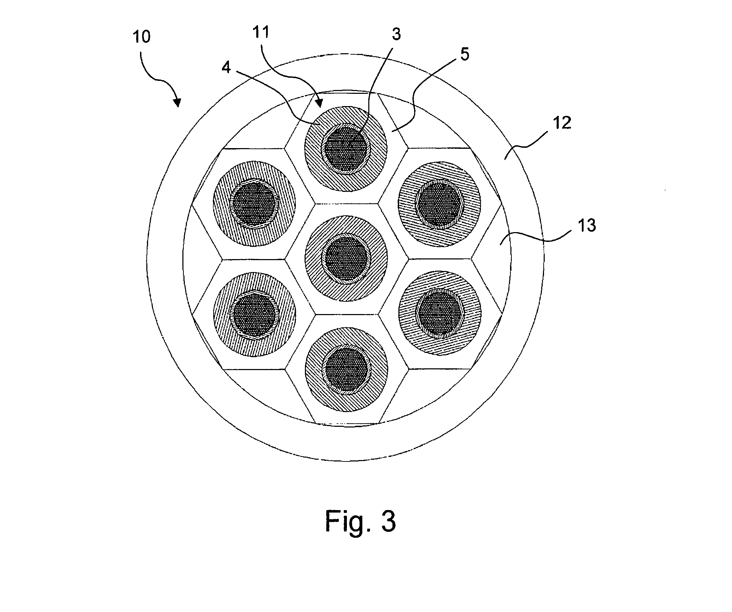

In der **Figur 3** ist im Querschnitt senkrecht zu seiner Längserstreckungsrichtung eine Ausführungsform einer erfindungsgemäßen Vorstufe 10 eines Supraleiterdrahts dargestellt.

In der Vorstufe 10 sind mehrere gezogene Monofilamente 11 (hier exemplarisch sieben Stück), die jeweils durch einen Filament-Ziehprozess aus einem Monofilament hervorgegangen sind, in einem Drahthüllrohr 12 ("Mantelrohr") gebündelt worden, und anschließend einem Extrusions- und/oder Draht-Ziehprozess zur Querschnittsreduktion unterzogen worden.

Das Drahthüllrohr 12 ist bevorzugt aus elementarem Kupfer gefertigt. Mittels Füllprofilen 13, die bevorzugt aus elementarem Kupfer gefertigt sind, werden Hohlräume am inneren Rand des Drahthüllrohrs 12 vermieden bzw. ausgefüllt.

Die Monofilamente wiesen hier bereits vor dem Filament-Ziehprozess einen hexagonalen Außenquerschnitt auf (vgl. Fig. 1), so dass beim Filament-Ziehprozess lediglich eine radiale Stauchung erfolgte; entsprechend weisen die äußeren Rohre **4** in den gezogenen Monofilamenten 11 nach wie vor einen runden Außenquerschnitt auf. Auch nach dem Extrusions- und/oder Draht-Ziehprozess der Vorstufe 10 bleibt der runde Außenquerschnitt eines jeden äußeren Rohrs 4 erhalten. Dadurch kann beim Reaktionsglühen die Reaktionsfront von $Nb_3Sn$, ausgehend vom Pulverkern 3, sich gleichmäßig konzentrisch dem äußeren Rand des äußeren Rohres 4 nähern; es gibt keine besonders dünnen Stellen, an denen Sn frühzeitig in das Hüllrohr 5 durchbrechen könnte, und es gibt auch keine besonders dicken Stellen, an denen für die Reaktion zu $Nb_3Sn$ nicht nutzbares Nb übersteht und übrigbleibt.

In der Figur 4 ist eine schematische Übersicht, die jeweils Querschnitte der angegebenen Komponenten zeigt, zur Fertigung eines erfindungsgemäßen Monofilaments 1 dargestellt.

Das innere Rohr 2 wird im Rahmen der hier gezeigten Fertigungsvariante mit dem Pulverkern 3 befüllt und einem Ziehschritt a) unterzogen. Dabei verringert sich der Querschnitt des vergleichsweise dünnwandigen inneren Rohrs 2, und der Pulverkern 3 wird verdichtet. Weiterhin wird das unbefüllte äußere Rohr 4 in einem Schritt b) in das Hüllrohr 5 (hier mit hexagonalem Außenquerschnitt) eingebracht. Die Schritte a) und b) können dabei in beliebiger Reihenfolge oder auch gleichzeitig stattfinden. Anschließend wird das gezogene und befüllte innere Rohr 2 in einem Schritt c) in das äußere Rohr 4, welches bereits im Hüllrohr 5 angeordnet ist, eingebracht.

Alternativ kann auch das gezogene, befüllte innere Rohr zunächst in das äußere Rohr eingebracht werden, und sodann das äußere Rohr in das Hüllrohr eingebracht werden (nicht gesondert dargestellt).

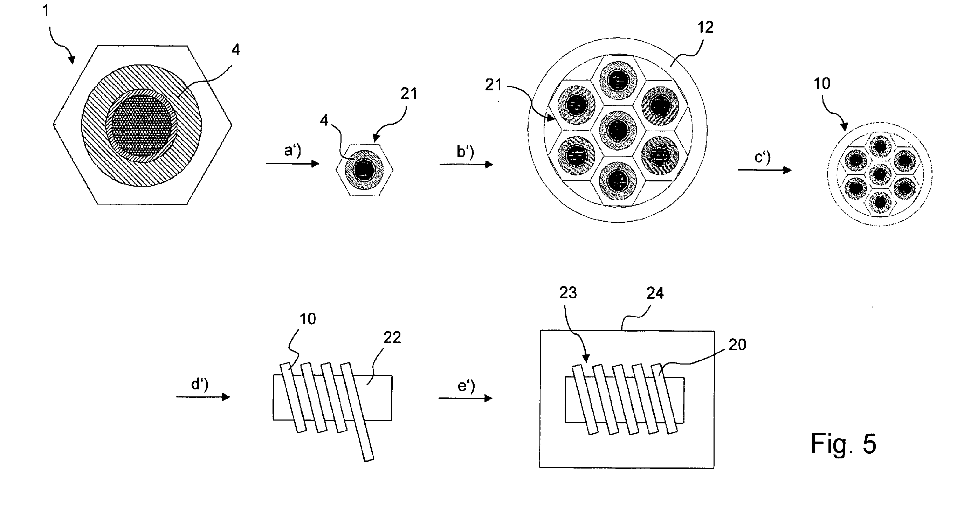

Die **Figur 5** illustriert schematisch den Ablauf der Fertigung eines Supraleiterdrahts 20 aus Monofilamenten 1, wie sie beispielsweise gemäß Fig. 4 hergestellt sind.

Ein Monofilament 1 wird durch Ziehen in einem Schritt a') ("Filament-Ziehprozess") in ein gezogenes Monofilament 21 überführt. Dabei wird die Querschnittsfläche verringert. Falls das Monofilament 1 bereits einen hexagonalen Außenquerschnitt aufweist (wie in Fig. 5 dargestellt), erfolgt beim Ziehen lediglich eine radiale Stauchung; dies ist bevorzugt, weil dann eine runder Außenquerschnitt des äußeren Rohrs 4 nach dem Ziehen gut erhalten werden kann. Falls das Monofilament 1 einen nicht-hexagonalen Außenquerschnitt (etwa einen runden Außenquerschnitt) aufweisen sollte, wird beim Ziehen gemäß a') auch ein hexagonale Außenquerschnitt aufgeprägt.

Mehrere gezogene Monofilamente 21 werden sodann in einem Schritt b') in einem Drahthüllrohr 12 gebündelt. Die Anzahl der gezogenen Monofilamente ist dabei grundsätzlich beliebig; in der gezeigten Variante werden sieben gezogene Monofilamente 21 gebündelt. Im Bündelbild können im Kernbereich die Monofilamente durch hexagonale Cu-Elemente ersetzt werden.

Sodann erfolgt in einem Schritt c') eine Extrusion und/oder ein Ziehen ("Draht-Ziehprozess"), was wiederum mit einer Querschnittsverringerung einher geht, und wodurch eine Vorstufe 10 eines Supraleiters erhalten wird. Diese Vorstufe 10 weist bereits die Querschnittsform und die Querschnittsgröße des zukünftigen Supraleiterdrahts auf, ist aber noch plastisch verformbar.

Um den Supraleiterdraht zu fertigen, ist es erforderlich, die Vorstufe 10 in einem Schritt d') in die für den zukünftigen Supraleiterdraht benötigte Form zu bringen; diese Form wird durch die gewünschte Anwendung des Supraleiterdrahts bestimmt. In der gezeigten Variante ist die Anwendung eine Magnetspule 23. Entsprechend wird die Vorstufe 10 auf einem Trägerkörper 22 aufgewickelt.

Daran schließt sich das Tempern ("Reaktionsglühen") der verformten Vorstufe in einem Schritt e') an. Die Magnetspule 23 wird dazu in einen Ofen 24 verbracht, der auf eine Temperatur von max. 700°C aufgeheizt wird. Bei dieser Temperatur reagiert das Sn aus den Pulverkernen mit dem Nb der inneren und äußeren Rohre in den Monofilamenten der Vorstufe zu $Nb_3Sn$. Bevor die Reaktionsfront den äußeren Rand der äußeren Rohre erreicht, wird das Tempern beendet. Die verformte Vorstufe ist durch das Tempern in einen Supraleiterdraht 20 umgewandelt worden, dessen $Nb_3Sn$-Filamente einen elektrischen Strom (bei entsprechender Kühlung, etwa mit flüssigem Helium) praktisch ohne ohmsche Verluste tragen können. Nach dem Tempern sollte der Supraleiterdraht 20 nicht mehr verformt werden, um einen Bruch der enthaltenen, spröden $Nb_3Sn$-Filamente zu vermeiden.

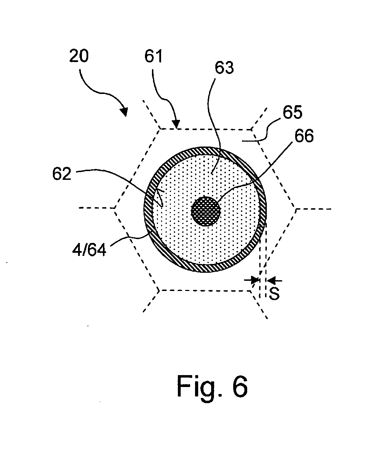

**Figur 6** illustriert in einem schematischen Querschnitt einen Ausschnitt aus dem Supraleiterdraht 20 im Bereich eines getemperten Monofilaments 61.

Eine Reaktionsfront 62 ist im getemperten Monofilament 61 radial von innen nach außen fortgeschritten und hat einen relativ homogenen, feinkörnigen Bereich 63 von $Nb_3Sn$ erzeugt. Die Reaktionsfront 62 hat jedoch das äußere Rohr 4 nicht vollständig durchschritten, sondern rundherum einen Saum 64 von unreagiertem Material des äußeren Hüllrohrs 4 (hier aus NbTa7,5, d.h. Nb mit 7,5Gew% Ta) belassen. Der Saum 64 weist über seinen gesamten Umfang eine näherungsweise gleichmäßige Stärke S auf; die Stärke S ist durch das Temperierungsprogramm gerade ausreichend groß eingestellt, um zuverlässig einen Durchbruch von Sn in die Matrix 65 (die aus den früheren Hüllrohren gebildet ist) aus Kupfer zu verhindern, und somit die elektrische Leitfähigkeit der Matrix 65 hoch zu halten. Aufgrund des runden äußeren Querschnitts des äußeren Rohrs 4 kann auch ein großer Anteil der Querschnittsfläche des Supraleiterdrahts 20 zu $Nb_3Sn$ reagieren; insbesondere bleiben keine unnützen Ausbuchtungen von Material des äußeren Rohrs 4 (wie sie an den Ecken eines außen hexagonalen äußeren Rohrs entstehen würden) erhalten.

Der runde Außenquerschnitt des äußeren Rohrs 4 kann durch einen hexagonalen Außenquerschnitt der Hüllrohre bereits vor dem Ziehen der Monofilamente (vgl. Schritt a') in Fig. 5) erhalten werden.

Im getemperten Monofilament 61 bleibt in der Regel ein aus dem Pulverkern hervorgehender Restkern 66, der von Sn abgereichert ist, erhalten.

Das getemperte Monofilament 61 ist im Wesentlichen frei von Spalten und Hohlräumen.

Literaturübersicht

- A.C.A. van Wees et al., IEEE Trans. Magn.; MAG 19, 556 (1983), S. 5-8;
- H. Veringa et al., Adv. Cryo. Eng. (Materials), 1984, 30; 813-821;
- W. L. Neijmeijer, B. H. Kolster, Journal of Less-Common Metals, 160 (1990), 161-170;
- EP 1 701 390 A2
- US 3,926,683
- T. Wong, C.V. Renaud, IEEE Trans. Appl. Supercond., Vol. 11, No. 1, March 2001, 3584-3587;
- JP 2006 252949 A
- US 2009/0011941 A1
- EP 0 169 596 A1
- S. Murase et al., IEEE Trans. Magn., Vol. Mag-21, No. 2, March 1985, S. 316- 319;
- DE 26 20 271 A1
- D. Rodrigues Jr. et al., Materials Research Vol. 3, No. 4, 2000, S. 99-103;
- JP 05 298 947 A

- JP 2004 193019 A
- JP 05 290 655 A
- J.F.Kunzler et al., Phys. Rev. Lett. 6 (1961), S. 89-97;
- J.D. Elen et al., IEEE Trans. Magn., MAG-13 (1977), No. 1, S. 470-473;

**Patentansprüche**

1.  Monofilament (1) zur Herstellung eines Supraleiterdrahts (20), mit

    - einem Pulverkern (3), der zumindest Sn und Cu enthält,
    - einem inneren Rohr (2), das den Pulverkern (3) umhüllt, wobei das innere Rohr (2) aus Nb oder einer Nb-haltigen Legierung gefertigt ist,
    - einem äußeren Rohr (4), in welchem das innere Rohr (2) angeordnet ist, wobei das innere Rohr (2) mit seiner Außenseite die Innenseite des äußeren Rohrs (4) berührt, und
    - einem Hüllrohr (5), in welchem das äußere Rohr (4) angeordnet ist, wobei das innere Rohr (2) einen runden Innenquerschnitt und einen runden Außenquerschnitt aufweist, und das äußere Rohr (4) einen runden Innenquerschnitt und einen runden Außenquerschnitt aufweist,
    **dadurch gekennzeichnet,**
    **dass** gilt

$$4 \leq W_{\text{äußeres Rohr}} / W_{\text{inneres Rohr}} \leq 50$$

    mit $W_{\text{äußeres Rohr}}$: Wandstärke äußeres Rohr (4) und $W_{\text{inneres Rohr}}$: Wandstärke inneres Rohr (2),
    und **dass** das äußere Rohr (4) aus Nb oder einer Nb-haltigen Legierung gefertigt ist.

2.  Monofilament (1) nach Anspruch 1, **dadurch gekennzeichnet, dass** das Hüllrohr (5) einen hexagonalen Außenquerschnitt und einen runden Innenquerschnitt aufweist.

3.  Monofilament (1) nach Anspruch 1 oder 2, **dadurch gekennzeichnet, dass** gilt

$$1,2 \leq D^{\text{außen}}_{\text{äußeres Rohr}} / D^{\text{außen}}_{\text{inneres Rohr}} \leq 2,0$$

    mit $D^{\text{außen}}_{\text{äußeres Rohr}}$: Außendurchmesser des äußeren Rohres (4) und
    $D^{\text{außen}}_{\text{inneres Rohr}}$: Außendurchmesser des inneren Rohres (2).

4.  Monofilament (1) nach einem der vorhergehenden Ansprüche, **dadurch gekennzeichnet, dass** der Pulverkern (3) einen Anteil von 2 Gew% bis 12 Gew% Cu aufweist, bevorzugt 3 bis 9 Gew% Cu, insbesondere wobei der Pulverkern (3) elementares Cu-Pulver enthält.

5.  Monofilament (1) nach einem der vorhergehenden Ansprüche, **dadurch gekennzeichnet, dass** der Pulverkern (3) im inneren Rohr (2) verdichtet vorliegt,
    insbesondere mit einer Dichte von wenigstens 40%, bevorzugt wenigstens 50% der theoretischen Dichte.

6.  Monofilament (1) nach einem der vorhergehenden Ansprüche, **dadurch gekennzeichnet, dass** der Pulverkern (3) $NbSn_2$ und/oder $Nb_6Sn_5$ und/oder elementares Sn enthält.

7.  Monofilament (1) nach einem der vorhergehenden Ansprüche, **dadurch gekennzeichnet, dass** das innere Rohr (2) und/oder das äußere Rohr (4) aus einer Nb-haltigen Legierung enthaltend Ta und/oder Ti gefertigt sind, insbesondere mit einem Gehalt von wenigstens 0,5 Gew% von Ta und/oder Ti in Summe, und insbesondere mit einem Gehalt von maximal 10 Gew% von Ta und/oder Ti in Summe.

8.  Monofilament (1) nach einem der vorhergehenden Ansprüche, **dadurch gekennzeichnet, dass** das innere Rohr (2) und das äußere Rohr (4) aus unterschiedlichen Materialien gefertigt sind.

**9.** Monofilament (1) nach einem der vorhergehenden Ansprüche, **dadurch gekennzeichnet, dass** das Hüllrohr (5) aus Cu gefertigt ist.

**10.** Verfahren zur Fertigung eines Monofilaments (1) nach einem der Ansprüche 1 bis 9, **gekennzeichnet durch** folgende Schritte:

a) der Pulverkern (3) wird zunächst in das ungezogene innere Rohr (2) gefüllt und anschließend wird das befüllte ungezogene innere Rohr (2) gezogen, wobei eine Verdichtung des Pulverkerns (3) eintritt;
b) das äußere Rohr (4) wird in das Hüllrohr (5) eingesetzt, und
c) das gezogene, befüllte innere Rohr (2) wird in das äußere Rohr (4) eingesetzt,

wobei Schritt b) vor oder nach Schritt c) stattfindet.

**11.** Verfahren nach Anspruch 10, **dadurch gekennzeichnet, dass** bereits vor Schritt b) das Hüllrohr (5) einen hexagonalen Außenquerschnitt aufweist.

**12.** Verfahren zur Fertigung einer Vorstufe (10) eines Supraleiterdrahts (20), **gekennzeichnet durch** folgende Schritte:

a') **durch** Ziehen eines oder mehrerer Monofilamente (1) nach einem der Ansprüche 1 bis 9 werden gezogene Monofilamente (11; 21) mit hexagonalem Außenquerschnitt gefertigt;
b') mehrere gezogene Monofilamente (11; 21) werden in einem Drahthüllrohr (12) gebündelt,
c') das Drahthüllrohr (12), das die gebündelten gezogenen Monofilamente (11; 21) enthält, wird extrudiert und/oder gezogen, wodurch die Vorstufe (10) des Supraleiterdrahts (20) erhalten wird.

**13.** Verfahren nach Anspruch 12, **dadurch gekennzeichnet, dass** in Schritt a') das oder die Monofilamente (1) bereits vor dem Ziehen einen hexagonalen Außenquerschnitt des Hüllrohrs (5) und einen runden Außenquerschnitt des äußeren Rohrs (4) aufweisen, und nach dem Ziehen die gezogenen Monofilamente (11; 21) ebenfalls einen hexagonalen Außenquerschnitt des Hüllrohrs (5) und einen runden Außenquerschnitt des äußeren Rohrs (4) aufweisen.

**14.** Vorstufe (10) eines Supraleiterdrahts (20), hergestellt durch ein Verfahren nach Anspruch 12 oder 13.

**15.** Verfahren zur Fertigung eines Supraleiterdrahts (20) aus einer Vorstufe (10) eines Supraleiterdrahts (20) nach Anspruch 14, **gekennzeichnet durch** folgende Schritte:

d') die Vorstufe (10) des Supraleiterdrahts (20) wird mechanisch verformt, insbesondere zu einer Spule (23) gewickelt;
e') die verformte Vorstufe (10) des Supraleiterdrahts (20) wird getempert, insbesondere bei einer maximalen Temperatur von 700°C oder weniger, wobei Nb aus dem inneren Rohr (2) und dem äußeren Rohr (4) mit Sn aus dem Pulverkern (3) zu $Nb_3Sn$ reagiert.

**16.** Verfahren nach Anspruch 15, **dadurch gekennzeichnet, dass** in Schritt e') das Tempern beendet wird, bevor eine nach außen fortschreitende Reaktionsfront (62) die Grenzfläche zwischen äußerem Rohr (4) und dem Hüllrohr (5) erreicht.

**17.** Supraleiterdraht (20), hergestellt durch ein Verfahren gemäß Anspruch 15 oder 16.

**Claims**

**1.** Monofilament (1) for the production of a superconducting wire (20), comprising

- a powder core (3) that contains at least Sn and Cu,
- an inner tube (2) that encloses the powder core (3), wherein the inner tube (2) is made of Nb or of an alloy containing Nb,
- an outer tube (4) in which the inner tube (2) is arranged, wherein the outer side of the inner tube (2) is in contact with the inner side of the outer tube (4), and
- a cladding tube (5) in which the outer tube (4) is arranged, wherein the inner tube (2) has a round inner cross-section and a round outer cross-section and the outer tube (4) has a round inner cross-section and a round outer cross-section,

**characterized in that**
the following applies:

$$4 \leq W_{outertube} \, / \, W_{innertube} \, \leq 50$$

with $W_{outertube}$ : Wall thickness outer tube (4) and $W_{innertube}$ : Wall thickness inner tube (2), and that the outer tube (4) is produced of Nb or an alloy containing Nb.

2. Monofilament (1) according to claim 1, **characterized in that** the cladding tube (5) has a hexagonal outer cross-section and a round inner cross-section.

3. Monofilament (1) according to claim 1 or 2, **characterized in that** the following applies:

$$1.2 \leq D^{outside}_{outertube} \, / \, D^{outside}_{innertube} \, \leq 2.0$$

with $D^{outside}_{outertube}$: outer diameter of the outer tube (4) and $D^{outside}_{innertube}$ : outer diameter of the inner tube (2).

4. Monofilament (1) according to any one of the preceding claims, **characterized in that** the powder core (3) has a content of 2 weight % to 12 weight % of Cu, preferably 3 to 9 weight % of Cu, in particular, wherein the powder core (3) contains elementary Cu powder.

5. Monofilament (1) according to any one of the preceding claims, **characterized in that** the powder core (3) is compacted in the inner tube (2), in particular, with a density of at least 40%, preferably at least 50% of the theoretical density.

6. Monofilament (1) according to any one of the preceding claims, **characterized in that** the powder core (3) contains $NbSn_2$ and/or $Nb_6Sn_5$ and/or elementary Sn.

7. Monofilament (1) according to any one of the preceding claims, **characterized in that** the inner tube (2) and/or the outer tube (4) are produced from an alloy containing Nb and containing Ta and/or Ti, in particular with a summed content of at least 0.5 weight % of Ta and/or Ti, and in particular, with a summed content of maximally 10 weight % of Ta and/or Ti.

8. Monofilament (1) according to any one of the preceding claims, **characterized in that** the inner tube (2) and the outer tube (4) are produced from different materials.

9. Monofilament (1) according to any one of the preceding claims, **characterized in that** the cladding tube (5) is made of Cu.

10. Method for producing a monofilament (1) according to any one of the claims 1 through 9, **characterized by** the following steps:

    a) the powder core (3) is initially filled into the undrawn inner tube (2) and the filled undrawn inner tube (2) is subsequently drawn, thereby compacting the powder core (3);
    b) the outer tube (4) is inserted into the cladding tube (5), and
    c) the drawn, filled inner tube (2) is inserted into the outer tube (4), wherein step b) is performed prior to or after step c).

11. Method according to claim 10, **characterized in that** the cladding tube (5) already has a hexagonal outer cross-section prior to step b).

**12.** Method for producing a precursor (10) of a superconducting wire (20), **characterized by** the following steps:

a') drawn monofilaments (11; 21) having a hexagonal outer cross-section are produced by drawing one or a plurality of monofilaments (1) as claimed in one of the claims 1 to 9;

b') a plurality of drawn monofilaments (11; 21) are bundled in a wire cladding tube (12);

c') the wire cladding tube (12) that contains the bundled and drawn monofilaments (11; 21) is extruded and/or drawn, thereby obtaining the precursor (10) of the superconducting wire (20).

**13.** Method according to claim 12, **characterized in that** in step a') the monofilament(s) (1) already has/have a hexagonal outer cross-section of the cladding tube (5) and a round outer cross-section of the outer tube (4) prior to drawing, and the drawn monofilaments (11; 21) also have a hexagonal outer cross-section of the cladding tube (5) and a round outer cross-section of the outer tube (4) after drawing.

**14.** Precursor (10) of a superconducting wire (20) produced by a method according to claim 12 or 13.

**15.** Method for producing a superconducting wire (20) from a precursor (10) of a superconducting wire (20) according to claim 14, **characterized by** the following steps:

d') the precursor (10) of the superconducting wire (20) is mechanically deformed, in particular, wound to form a coil (23);

e') the deformed precursor (10) of the superconducting wire (20) is temperature-treated, in particular, at a maximum temperature of 700°C or less, wherein Nb from the inner tube (2) and the outer tube (4) reacts with Sn from the powder core (3) to form $Nb_3Sn$.

**16.** Method according to claim 15, **characterized in that** temperature treatment is terminated in step e') before a reaction front (62) that advances to the outside has reached the boundary surface between the outer tube (4) and the cladding tube (5).

**17.** Superconducting wire (20) produced by a method in accordance with claim 15 or 16.

**Revendications**

**1.** Monofilament (1) pour la fabrication d'un fil supraconducteur (20), comprenant

- un noyau en poudre (3) qui contient au moins Sn et Cu,
- un tube intérieur (2) qui enveloppe le noyau en poudre (3), le tube intérieur (2) étant réalisé en Nb ou dans un alliage à base de Nb,
- un tube extérieur (4) dans lequel le tube intérieur (2) est disposé, le tube intérieur (2) étant en contact par son côté extérieur avec le côté intérieur du tube extérieur (4), et
- un tube enveloppe (5) dans lequel le tube extérieur (4) est disposé, le tube intérieur (2) présentant une section intérieure ronde et une section extérieure ronde, et le tube extérieur (4) présentant une section intérieure ronde et une section extérieure ronde,

**caractérisé en ce qu'**il s'applique

$$4 \leq W_{\text{tube extérieur}} / W_{\text{tube intérieur}} \leq 50$$

avec $W_{\text{tube extérieur}}$ : épaisseur de paroi du tube extérieur (4) et $W_{\text{tube intérieur}}$ : épaisseur de paroi du tube intérieur (2), et **que** le tube extérieur (4) est réalisé en Nb ou dans un alliage à base de Nb.

**2.** Monofilament (1) selon la revendication 1, **caractérisé en ce que** le tube enveloppe (5) présente une section extérieure hexagonale et une section intérieure ronde.

**3.** Monofilament (1) selon la revendication 1 ou 2, **caractérisé en ce qu'**il s'applique

$$1{,}2 \leq D^{\text{extérieur}}{}_{\text{tube extérieur}} / D^{\text{extérieur}}{}_{\text{tube intérieur}} \leq 2{,}0$$

avec $D^{\text{extérieur}}$ tube $_{\text{extérieur}}$ : diamètre extérieur du tube extérieur (4) et $D^{\text{extérieur}}$ tube intérieur : diamètre extérieur du tube intérieur (2).

4.  Monofilament (1) selon l'une des revendications précédentes, **caractérisé en ce que** le noyau en poudre (3) présente une proportion de 2 % en poids à 12 % en poids de Cu, de préférence de 3 à 9 % en poids de Cu, en particulier le noyau en poudre (3) contenant de la poudre de Cu élémentaire.

5.  Monofilament (1) selon l'une des revendications précédentes, **caractérisé en ce que** le noyau en poudre (3) est présent sous forme comprimée dans le tube intérieur (2), en particulier avec une densité d'au moins 40 %, de préférence d'au moins 50 % de la densité théorique.

6.  Monofilament (1) selon l'une des revendications précédentes, **caractérisé en ce que** le noyau en poudre (3) contient $NbSn_2$ et/ou $Nb_6Sn_5$ et/ou Sn sous forme élémentaire.

7.  Monofilament (1) selon l'une des revendications précédentes, **caractérisé en ce que** le tube intérieur (2) et/ou le tube extérieur (4) sont réalisés à partir d'un alliage à base de Nb contenant Ta et/ou Ti, en particulier avec une teneur d'au moins 0,5 % en poids de Ta et/ou Ti au total, et en particulier avec une teneur d'au maximum 10 % en poids de Ta et/ou Ti au total.

8.  Monofilament (1) selon l'une des revendications précédentes, **caractérisé en ce que** le tube intérieur (2) et le tube extérieur (4) sont réalisés dans des matériaux différents.

9.  Monofilament (1) selon l'une des revendications précédentes, **caractérisé en ce que** le tube enveloppe (5) est réalisé en Cu.

10. Procédé de fabrication d'un monofilament (1) selon l'une des revendications 1 à 9, **caractérisé par** les étapes suivantes :

    a) le noyau en poudre (3) est d'abord versé dans le tube intérieur (2) non étiré, puis le tube intérieur (2) non étiré rempli est étiré, à l'occasion de quoi il se produit une compression du noyau en poudre (3) ;
    b) le tube extérieur (4) est inséré dans le tube enveloppe (5), et
    c) le tube intérieur (2) étiré rempli est inséré dans le tube extérieur (4),

    l'étape b) ayant lieu avant ou après l'étape c).

11. Procédé selon la revendication 10, **caractérisé en ce que** le tube enveloppe (5) présente une section extérieure hexagonale déjà avant l'étape b).

12. Procédé de fabrication d'un précurseur (10) d'un fil supraconducteur (20), **caractérisé par** les étapes suivantes :

    a') des monofilaments étirés (11 ; 21) de section extérieure hexagonale sont fabriqués par étirage d'un ou plusieurs monofilaments (1) selon l'une des revendications 1 à 9 ;
    b') plusieurs monofilaments étirés (11 ; 21) sont mis en faisceau dans un tube enveloppe de fils (12),
    c') le tube enveloppe de fils (12) qui contient les monofilaments (11 ; 21) étirés en faisceau est extrudé et/ou étiré, moyennant quoi le précurseur (10) du fil supraconducteur (20) est obtenu.

13. Procédé selon la revendication 12, **caractérisé en ce qu'**à l'étape a'), le ou les monofilament(s) (1) présente(nt) une section extérieure hexagonale du tube enveloppe (5) et une section extérieure ronde du tube extérieur (4) déjà avant l'étirage, et qu'après l'étirage, les monofilaments étirés (11 ; 21) présentent également une section extérieure hexagonale du tube enveloppe (5) et une section extérieure ronde du tube extérieur (4).

14. Précurseur (10) d'un fil supraconducteur (20), fabriqué par un procédé selon la revendication 12 ou 13.

15. Procédé de fabrication d'un fil supraconducteur (20) à partir d'un précurseur (10) d'un fil supraconducteur (20) selon la revendication 14, **caractérisé par** les étapes suivantes :

> d') le précurseur (10) du fil supraconducteur (20) est mis en forme mécaniquement, en particulier enroulé en une bobine (23) ;
>
> e') le précurseur (10) mis en forme du fil supraconducteur (20) est trempé, en particulier à une température maximale de 700 °C ou moins, à l'occasion de quoi Nb du tube intérieur (2) et du tube extérieur (4) réagit avec Sn du noyau en poudre (3) pour former $Nb_3Sn$.

16. Procédé selon la revendication 15, **caractérisé en ce qu'**à l'étape e'), la trempe est arrêtée avant qu'un front de réaction (62) progressant vers l'extérieur n'atteigne la surface limite entre tube extérieur (4) et tube enveloppe (5).

17. Fil supraconducteur (20), fabriqué par un procédé selon la revendication 15 ou 16.

Fig. 2

Fig. 1

Fig. 3

Fig. 4

Fig. 5

Fig. 6

EP 2 779 258 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0169596 A1
- EP 1705721 A2
- WO 2006010364 A1
- EP 1701390 A2
- US 3926683 A
- JP 2006252949 A
- US 20090011941 A1
- DE 2620271 A1
- JP 05298947 A
- JP 2004193019 A
- JP 05290655 A

**In der Beschreibung aufgeführte Nicht-Patentliteratur**

- **H. VERINGA et al.** *Adv. Cryo. Eng. (Materials),* 1984, vol. 30, 813-821
- **A.C.A. VAN WEES et al.** *IEEE Trans. Magn., MAG,* 1983, vol. 19 (556), 5-8
- **A.C.A. VAN WEES et al.** *IEEE Trans. Magn.; MAG,* 1983, vol. 19 (556), 5-8
- **W. L. NEIJMEIJER ; B. H. KOLSTER.** *Journal of Less-Common Metals,* 1990, vol. 160, 161-170
- **T. WONG ; C.V. RENAUD.** *IEEE Trans. Appl. Supercond.,* Marz 2001, vol. 11 (1), 3584-3587
- **S. MURASE et al.** *IEEE Trans. Magn.,* Marz 1985, vol. Mag-21 (2), 316-319
- **D. RODRIGUES JR. et al.** *Materials Research,* 2000, vol. 3 (4), 99-103
- **J.F.KUNZLER et al.** *Phys. Rev. Lett,* 1961, vol. 6, 89-97
- **J.D. ELEN et al.** *IEEE Trans. Magn.,* 1977, vol. MAG-13 (1), 470-473